# EUROPEAN PATENT APPLICATION

(11) **EP 3 244 480 A1**
(43) Date of publication of application: **15.11.2017**
(21) Application number: 15876823.4
(22) Date of filing: 06.01.2015
(51) Int. Cl.: H01P 3/08, H01L 23/12, H01P 5/02

(54) **MULTILAYER CIRCUIT BOARD**

(71) Applicant: Mitsubishi Electric Corporation, Chiyoda-ku Tokyo 100-8310 (JP)
(72) Inventor: KOMATSU, Shoji, Tokyo 100-8310 (JP); HIROTA, Akimichi, Tokyo 100-8310 (JP); TAHARA, Yukihiro, Tokyo 100-8310 (JP); SHIBUYA, Koji, Tokyo 100-8310 (JP); AKEBOSHI, Yoshihiro, Tokyo 100-8310 (JP)
(74) Representative: Pfenning, Meinig & Partner mbB
(86) International application number: PCT/JP2015/050152
(87) International publication number: WO 2016/110945

(57) **Abstract**

A first ground elimination portion 3a formed in a ground layer is formed in a size such that a characteristic impedance determined by the first ground elimination portion 3a and component pads 1a is higher than a characteristic impedance determined by a ground conductor 2a and a transmission line 1b. When an outer shapes of the component pads 1a are projected on the ground layer, the center of a region interposed between the conductor pads 1a is positioned at the center of the first ground elimination portion 3a.

## Description

### TECHNICAL FIELD

The present invention relates to a multilayer circuit board formed by laminating at least one signal layer and at least one ground layer with an insulating layer interposed therebetween.

### BACKGROUND ART

In recent years, high-speed digital transmission has been developed greatly, and increase in reflection characteristic due to characteristic impedance mismatching becomes significant. In particular, a pad for mounting a chip component or a connector thereon is formed wider than a transmission line, and thus a desired characteristic impedance of the pad cannot be obtained. As a result, there is a problem that occurrence of mismatching of the characteristic impedance causes reflection in the pad.

To solve the problem with respect to the above-mentioned characteristic impedance mismatching in the pad, a technique for obtaining a desired characteristic impedance by eliminating a part of a ground of the pad is known (for example, Patent Literature 1).

### CITATION LIST

### PATENT LITERATURE

Patent Literature 1: Japanese Unexamined Utility Model Application Publication No. S55-25339 (1980-25339)

### SUMMARY OF INVENTION

### TECHNICAL PROBLEM

However, in a conventional technique described in the above Patent Literature 1, in the case where a deviation occurs in the lamination when the board is manufactured, the characteristic impedance in the pad varies significantly from a desired value, and hence there is a problem that the reflection characteristic in the pad is deteriorated.

The present invention is implemented to solve the above-described problem, and it is an object of the present invention to provide a multilayer circuit board in which the characteristic impedance of a pad does not deviate greatly from a desired value even when a deviation in lamination occurs to thereby suppress the deterioration of the reflection characteristic.

### SOLUTION TO PROBLEM

A multilayer circuit board is formed by laminating at least one signal layer and at least one ground layer with an insulating layer interposed therebetween. The multilayer circuit board includes: a transmission line formed in the signal layer; at least one conductor pad that is formed in the signal layer and connected to the transmission line, and that is wider than the transmission line; a ground conductor that is formed in the ground layer, and that has a first ground elimination portion in which a conductor is not disposed; and an auxiliary ground conductor that is disposed inside the first ground elimination portion and that is connected to the ground conductor. The first ground elimination portion is formed in a size such that a characteristic impedance determined by the first ground elimination portion and the at least one conductor pad is higher than a characteristic impedance determined by the ground conductor and the transmission line.

### ADVANTAGEOUS EFFECTS OF INVENTION

In the multilayer circuit board according to the present invention, the first ground elimination portion formed in the ground layer is configured to be formed in a size such that the characteristic impedance determined by the first ground elimination portion and the conductor pad is higher than the characteristic impedance determined by the ground conductor and the transmission line. In this manner, even when a lamination deviation occurs, the characteristic impedance does not deviate greatly from a desired value, so that deterioration of the reflection characteristic can be suppressed.

### BRIEF DESCRIPTION OF DRAWINGS

Fig. 1 is a configuration diagram schematically showing a multilayer circuit board according to an Embodiment 1 of the present invention;
Fig. 2 is a cross-sectional view taken along a line X₁-X₂ in Fig. 1;
Fig. 3 is an explanatory view in a case where a lamination deviation occurs in the multilayer circuit board according to the Embodiment 1 of the present invention;
Fig. 4 is a cross-sectional view taken along a line X₁-X₂ in Fig. 3;
Fig. 5 is a configuration diagram schematically showing a conventional multilayer circuit board;
Fig. 6 is a cross-sectional view taken along a line X₁-X₂ in Fig. 5;
Fig. 7 is an explanatory view in which a lamination deviation occurs in the conventional multilayer circuit board;
Fig. 8 is a cross-sectional view taken along a line X₁-X₂ in Fig. 7;
Fig. 9 is an explanatory view which shows analysis results in reflection characteristics according to the multilayer circuit board according to the Embodiment 1 of the present invention and the conventional multilayer circuit board;
Fig. 10 is a configuration diagram schematically showing a multilayer circuit board according to an Embodiment 2 of the present invention;
Fig. 11 is an explanatory view in the case where a lamination deviation occurs in the multilayer circuit board according to the Embodiment 2 of the present invention;
Fig. 12 is a configuration diagram schematically showing a multilayer circuit board according to an Embodiment 3 of the present invention; and
Fig. 13 is a cross-sectional view taken along a line X₁-X₂ in Fig. 12.

### DESCRIPTION OF EMBODIMENTS

Hereinafter, some Embodiments for carrying out the present invention will be described with reference to the accompanying drawings to explain the present invention in more detail.

### Embodiment 1

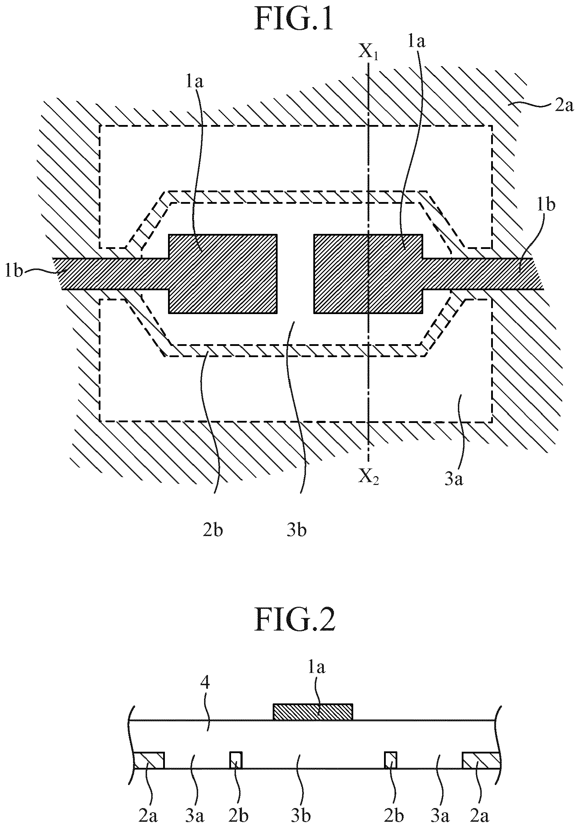

Fig. 1 is a configuration diagram schematically showing a multilayer circuit board according to this Embodiment, and Fig. 2 is a cross-sectional view taken along a line X₁-X₂ in Fig. 1. In the Embodiment 1, a case where a multilayer circuit board is constituted by a microstrip line is shown.

As shown in these figures, in the multilayer circuit board of the Embodiment 1, a signal layer (signal transmitting conductor: component pad (conductor pad) 1a and transmission line 1b), and a ground layer (ground conductor 2a and auxiliary ground conductor 2b) are formed in upper and lower layers of a dielectric layer (insulating layer) 4, respectively. Further, ground elimination portions (a first ground elimination portion 3a and a second ground elimination portion 3b) are formed in the ground layer.

The signal transmitting conductor is formed as follows: the two component pads 1a which is formed to be a pair are arranged close to each other at one end sides thereof, and the other end sides of the component pads 1a are connected to transmission lines 1b, respectively. In addition, the auxiliary ground conductor 2b is arranged inside the first ground elimination portion 3a formed in the ground layer, and the second ground elimination portion 3b is also arranged inside the auxiliary ground conductor 2b. The auxiliary ground conductor 2b is electrically connected to the ground conductor 2a.

In this way, in the multilayer circuit board of the Embodiment 1, the first ground elimination portion 3a surrounded by the ground conductor 2a is formed in the ground layer, and the auxiliary ground conductor 2b electrically connected to the ground conductor 2a is arranged inside the first ground elimination portion 3a, and the second ground elimination portion 3b surrounded by the auxiliary ground conductor 2b is also formed.

In this case, the first ground elimination portion 3a is formed in a size such that the characteristic impedance determined by the first ground elimination portion 3a and the component pad 1a is higher than the characteristic impedance determined by the ground conductor 2a and the transmission line 1b. A relationship between these characteristic impedances will be described later.

In addition, it is configured that when an outer shapes of the pair of component pads 1a are projected on the ground layer, a center of a region between the component pads 1a is arranged at a center of the first ground elimination portion 3a, and that when the outer shapes of the component pads 1a are projected on the ground layer, the outer shapes are arranged inside the second ground elimination portion 3b. Additionally, the auxiliary ground conductor 2b is arranged in a manner such that the center of the auxiliary ground conductor 2b is positioned at the center of the first ground elimination portion 3a.

Further, each of the auxiliary ground conductor 2b and the first ground elimination portion 3a has a shape of line symmetry.

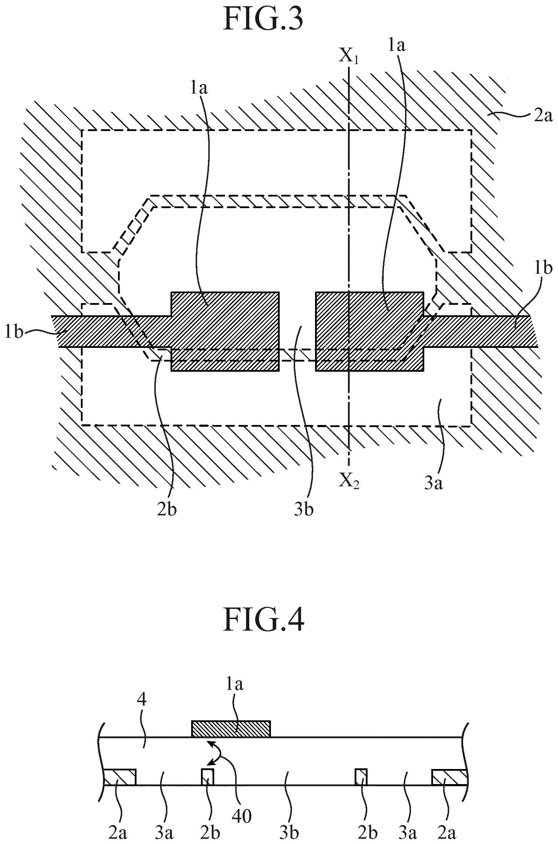

Figs. 1 and 2 show the configuration of the multilayer circuit board according to the Embodiment 1 in a situation where no lamination deviation occurs. On the other hand, Figs. 3 and 4 show the configuration of a multilayer circuit board according to the Embodiment 1 in a situation where a lamination deviation occurs. Fig. 3 is a partial plan view corresponding to Fig. 1, and Fig. 4 is a cross-sectional view taken along a line X₁-X₂ in Fig. 3 and corresponding to Fig. 2. The reflection characteristic in the case where the above lamination deviation occurs will be described in comparison with that of a conventional configuration.

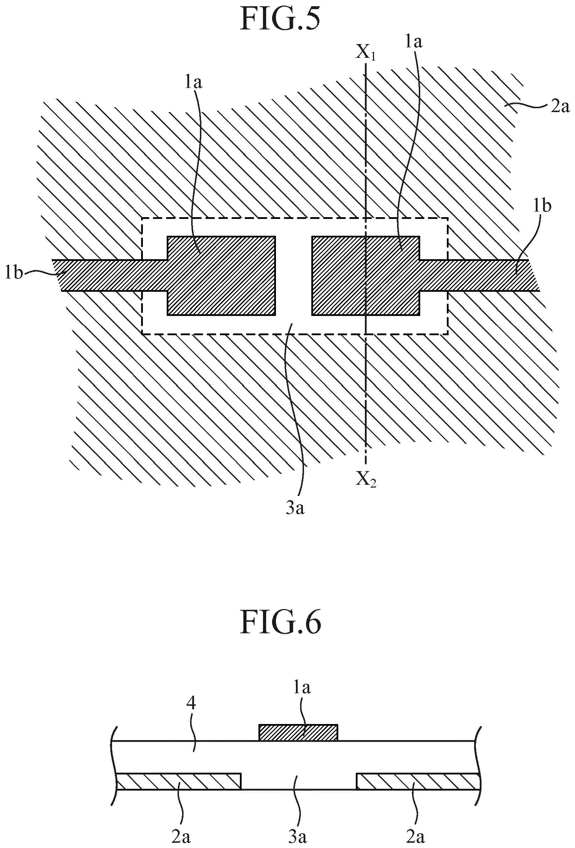

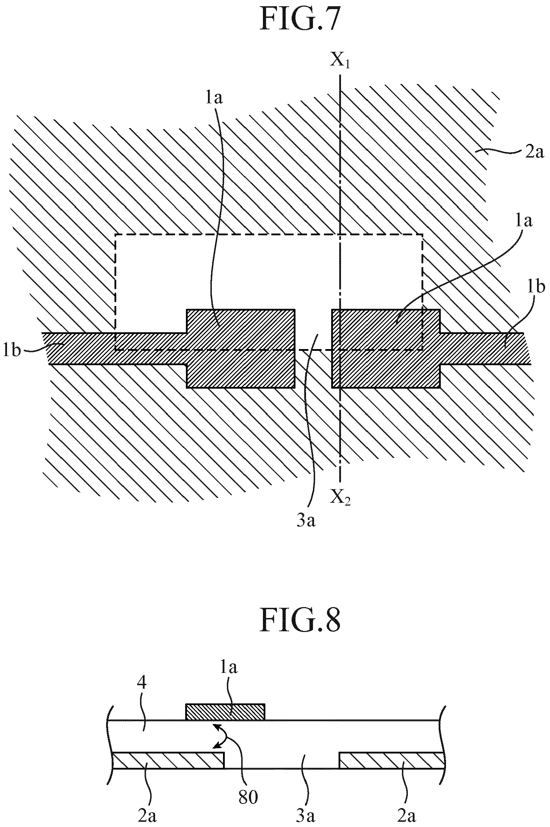

In a conventional configuration, Figs. 5 and 6 show a situation where no lamination deviation occurs, and Figs. 7 and 8 show a situation where a lamination deviation occurs. Figs. 5 and 7 are partial plan views, and Figs. 6 and 8 are cross-sectional views taken along lines X₁-X₂ in Figs. 5 and 7, respectively. In these figures, a component pad 1a, a transmission line 1b, a ground conductor 2a and an auxiliary ground conductor 2b have constitutions similar to those of Figs. 1 to 4, and a ground elimination portion 3a is a portion corresponding to the first ground elimination portion 3a in Figs. 1 to 4.

For the situations of presence/absence of the lamination deviation in the multilayer circuit board of the Embodiment 1 shown in Figs. 1 to 4 and the conventional multilayer circuit boards shown in Figs. 5 to 8, their reflection characteristics are analyzed.

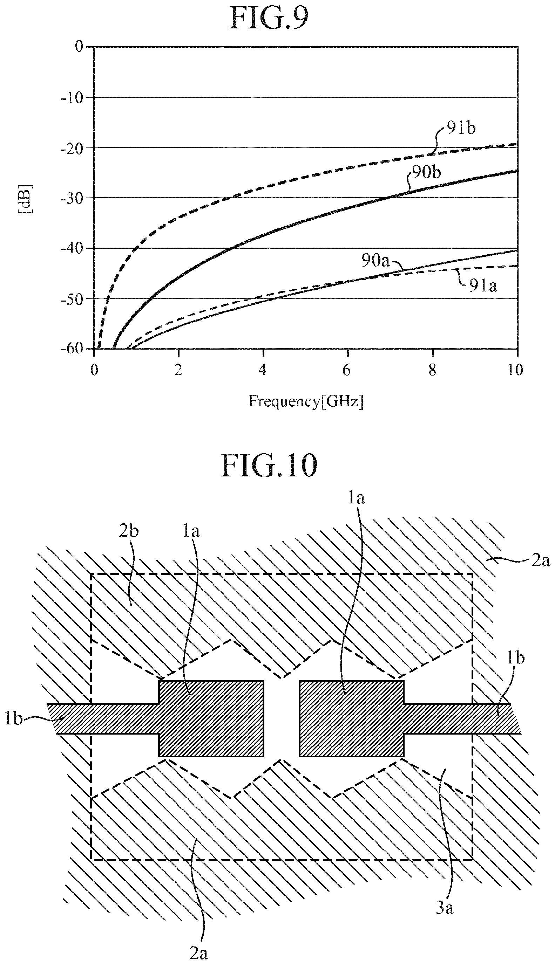

Fig. 9 shows analysis results of the reflection characteristics in the multilayer circuit boards of the Embodiment 1 and the conventional multilayer circuit boards, with respect to the presence/absence of the lamination deviation. In Fig. 9, solid lines 90a, 90b show the reflection characteristics according to the multilayer circuit boards of the Embodiment 1, and dotted lines 91a, 91b show the reflection characteristics according to the conventional multilayer circuit boards of the Embodiment 1. The solid line 90a and the dotted line 91a represent the characteristics of the configuration of the Embodiment 1 and the conventional configuration at reference positions without lamination deviation, respectively. The solid line 90b and the dotted line 91b represent the characteristics of the configuration of the Embodiment 1 and the conventional configuration when the lamination deviations occur, respectively.

As shown in Fig. 9, it can be understood that in the multilayer circuit board of the Embodiment 1, the reflection characteristics are significantly improved when the lamination deviation occurs, in comparison with the conventional configuration.

In the conventional multilayer circuit board, an overlapping area between the component pad 1a and the ground layer 2 when the lamination deviation occurs is larger than that of the Embodiment 1 when the lamination deviation occurs. Thus, in the conventional multilayer circuit board, the variation of the capacitance therebetween is larger, and as a result, mismatching of the characteristic impedance is larger, which leads to deterioration of the reflection characteristic.

On the other hand, in the Embodiment 1, it is configured that the auxiliary ground conductor 2b and the second ground elimination portion 3b are arranged inside the first ground elimination portion 3a in a microstrip line. In this configuration, even when the lamination deviation occurs as shown in Figs. 3 and 4, the area in which the component pad 1a and the ground layer 2 overlap with each other can be made smaller than that of the conventional multilayer circuit board. As a result, the variation of the capacitance therebetween can be made smaller, and thus the mismatching of the characteristic impedance can be made smaller, so that the reflection characteristic can be kept in a preferable state. Hereinafter, this point will be described in more detail.

The characteristic impedance Z is given by the formula Z = (L/C) ^ 1/2. In this equation, L is the inductance and C is the capacitance. Generally, if the characteristic impedance Z from input to output is not designed to be constant as much as possible, the reflection characteristic is deteriorated. Therefore, the design is executed so that the characteristic impedance Zcp of the component pad 1a at the reference position is almost the same as the characteristic impedance Zct of the transmission line 1b connected to the component pad 1a. In a case where the lamination deviation occurs, only the variation of the capacitances with respect to the component pad 1a and the transmission line 1b arises, and thus, the mismatching of the characteristic impedance occurs, so that the reflection characteristic is deteriorated. The relationship is as follows.
- The variation of the capacitance is large. --> The mismatching of the characteristic impedance is large. --> The reflection characteristic is deteriorated.
- The variation of the capacitance is small. --> The mismatching of the characteristic impedance is small. --> The reflection characteristic is preferable.

In order to keep a preferable reflection characteristic, it is important to suppress the variation in capacitance and keep the capacitance to be constant as much as possible even when the lamination deviation occurs. In the conventional configuration (Figs. 5 and 6), the size of the first ground elimination portion 3a is determined so that the relation Zcp = Zct is attained in the reference position. In such a conventional configuration, when the lamination deviation occurs (Figs. 7 and 8), the overlapping area between the component pad 1a and the ground conductor 2a is large, so that the variation of the capacitance is large (see the arrow 80). In contrast, in the Embodiment 1, the size of the first ground elimination portion 3a is made wider than that of the first ground elimination portion 3a in Fig. 5 so that the variation of the capacitance between the component pad 1a and the ground conductor 2a is small (see the arrow 40) even when the lamination deviation occurs. In this manner, the following relationship is established: The first ground elimination portion 3a is made wider. = The variation of the capacitance is made smaller. = Zcp is made higher than Zct. That is to say, the condition that Zcp is made higher than Zct means the following condition: "Even when the lamination deviation occurs, the characteristic impedance does not deviate greatly from a desired one."

In addition, with respect to the auxiliary ground conductor 2b, it is necessary to satisfy the following conditions: matching between Zcp and Zct can be achieved at the reference position (this is because the area of the first ground elimination portion 3a is made wider); and the shape of the auxiliary ground conductor is designed such that, when the lamination deviation occurs, the overlapping area between the component pad 1a and the auxiliary ground conductor 2b is made smaller than that of the conventional configuration.

Note that, as is apparent from Fig. 9, when no lamination deviation occurs, it is possible to obtain a similar value between the reflection characteristics obtained in the multilayer circuit board of the Embodiment 1 and the conventional multilayer circuit board (see solid line 90a and dotted line 91a).

As described above, according to the multilayer circuit board of the Embodiment 1, the multilayer circuit board is formed by laminating at least one signal layer and at least one ground layer to sandwich an insulating layer. The multilayer circuit board includes the following components: a transmission line formed in the signal layer; a conductor pad that is formed in the signal layer and connected to the transmission line, and whose width is wider than the width of the transmission line; a ground conductor that is formed in the ground layer, and that has a first ground elimination portion in which a conductor is not disposed; and an auxiliary ground conductor that is disposed inside the first ground elimination portion and that is connected to the ground conductor. The first ground elimination portion is formed in a size such that the characteristic impedance determined by the first ground elimination portion and the conductor pad is higher than the characteristic impedance determined by the ground conductor and the transmission line. Thus, even when the lamination deviation occurs, the characteristic impedance does not deviate greatly from a desired value, and as a result, deterioration of the reflection characteristic can be suppressed.

Further, according to the multilayer circuit board of the Embodiment 1, a pair of the conductor pads are configured, and when the outer shapes of the conductor pads are projected on the ground layer, the center of the region between the conductor pads is positioned at the center of the first ground elimination portion. Thus, mismatching in the characteristic impedance can be suppressed so that deterioration of the reflection characteristic can be suppressed.

Moreover, according to the multilayer circuit board of the Embodiment 1, the center of the auxiliary ground conductor 2b is arranged at the center of the first ground elimination portion 3a, and thus the mismatching of the characteristic impedance can be decreased, so that the deterioration of the reflection characteristic can be suppressed.

Moreover, according to the multilayer circuit board of the Embodiment 1, the auxiliary ground conductor 2b has a second ground elimination portion 3b inside, and when an outer shapes of the conductor pads are projected on the ground layer, the projection of the conductor pads are arranged inside the second ground elimination portion 3b, and thus the mismatching of the characteristic impedance can be decreased, so that the deterioration of the reflection characteristic can be suppressed.

Moreover, according to the multilayer circuit board of the Embodiment 1, each of the auxiliary ground conductor 2b and the first ground elimination portion 3a has a shape of line symmetry, and thus the mismatching of the characteristic impedance can be decreased, so that the deterioration of the reflection characteristic can be suppressed.

### Embodiment 2

In the Embodiment 2, a surface of the auxiliary ground conductor 2b facing the component pad 1a is configured to have an alternating convex and concave shape. Hereinafter, as in the Embodiment 1, an example where a multilayer circuit board is constituted by a microstrip line will be described.

The Embodiment 1 shows the configuration in which the auxiliary ground conductor 2b having the second ground elimination portion 3b is electrically connected to the ground conductor 2a. On the other hand, the Embodiment 2 shows a case in which even when the lamination deviation occurs, an overlapping area between the component pad 1a and the ground layer can be suppressed by modifying the shape of the first ground elimination portion 3a.

Fig. 10 is a configuration diagram schematically showing a multilayer circuit board of the Embodiment 2. The multilayer circuit board of the Embodiment 2 is obtained by eliminating the second ground elimination portion 3b from the multilayer circuit board of the Embodiment 1 shown in Figs. 1 to 4, and forming the surface of the auxiliary ground conductor 2b facing the component pad 1a to be an alternating convex and concave shape. In other words, this configuration is equivalent to the one in which the side surface shape of the first ground elimination portion 3a is configured to have an alternating convex and concave shape. Additionally, similarly to the Embodiment 1, the first ground elimination portion 3a is formed in a size such that the characteristic impedance determined by the first ground elimination portion 3a and the component pad 1a is higher than that determined by the ground conductor 2a and the transmission line 1b. Since the other components are the same as those of the Embodiment 1, the same signs are denoted to the corresponding parts, and these descriptions will be omitted.

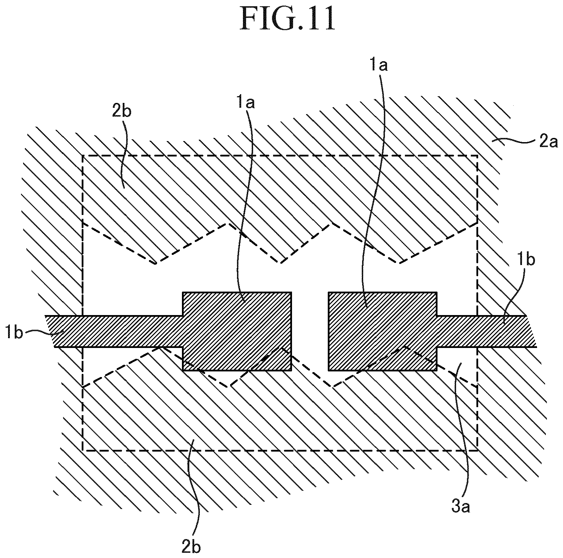

In the multilayer circuit board of the Embodiment 2, in the microstrip line, the side surface shape of the first ground elimination portion 3a is configured to have an alternating convex and concave shape, and thus, when the lamination deviation occurs, the overlapping area between the component pad 1a and the ground layer (the ground conductor 2a and the auxiliary ground conductor 2b) can be made smaller than that of the conventional multilayer circuit board. Fig. 11 is an explanatory view showing a situation in which the lamination deviation occurs in the multilayer circuit board of the Embodiment 2. It can be understood that the overlapping area between the component pad 1a and the ground conductor 2a or the auxiliary ground conductor 2b is smaller as compared to the case where the lamination deviation occurs in the conventional configuration in Fig. 7.

In this manner, in the multilayer circuit board of the Embodiment 2, it is configured that the overlapping area between the component pad 1a and the ground layer is made smaller even when the lamination deviation occurs. Thus, similarly to the Embodiment 1, the variation of the capacitance is suppressed, and as a result, mismatching of the characteristic impedance is decreased, thereby improving the reflection characteristic.

Note that, when no lamination deviation exists, substantially equivalent values can be obtained in the reflection characteristics between the multilayer circuit board of the Embodiment 2 and the conventional multilayer circuit board in which the conductor in the first ground elimination portion 3a is eliminated from the ground layer.

As described above, according to the multilayer circuit board of the Embodiment 2, it is configured that the surface of the auxiliary ground conductor facing to the conductor pads has an alternating convex and concave shape. Thus, even when the lamination deviation occurs, the characteristic impedance does not deviate greatly from a desired value, so that deterioration of the reflection characteristic can be suppressed.

### Embodiment 3

In the Embodiments 1 and 2, the configuration using a microstrip line is shown. In contrast, a configuration using a strip line is shown in the Embodiment 3.

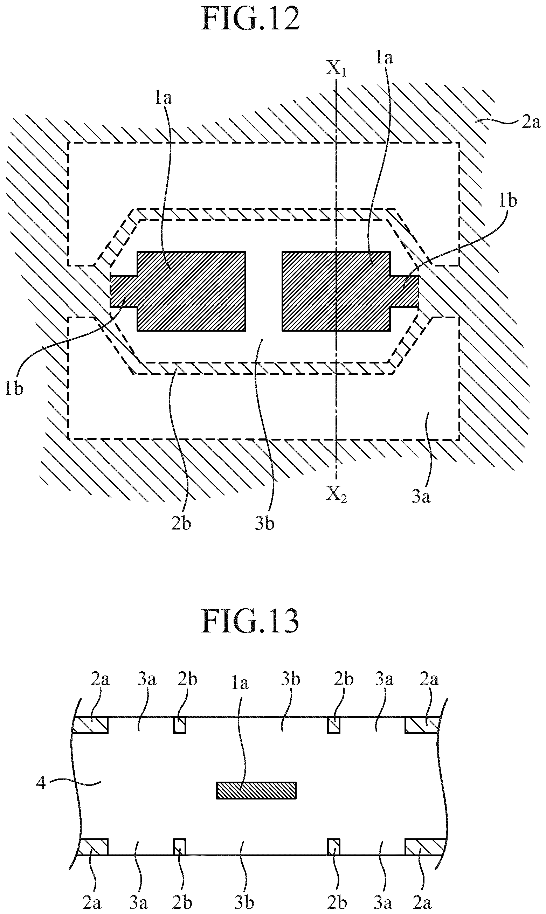

Fig. 12 is a configuration diagram schematically showing a multilayer circuit board of the Embodiment 3, and Fig. 13 is a cross-sectional view taken along a line X₁-X₂ in Fig. 12.

As shown in these figures, the ground layers respectively formed on the upper and lower sides of a signal transmission conductor (the component pads 1a, the transmission lines 1b) function as reference grounds. In each of the upper and lower ground layers, similarly to the Embodiment 1, a ground conductor 2a, an auxiliary ground conductor 2b, a first ground elimination portion 3a, and a second ground elimination portion 3b are formed.

In the Embodiment 3, the auxiliary ground conductor 2b, and the first ground elimination portion 3a, and the second ground elimination portion 3b, which are similar to those of the Embodiment 1, are disposed in each of the upper and lower ground layers in a strip line. Thus, when the lamination deviation occurs, an overlapping area between the component pad 1a and the ground layer can be made smaller than that of the conventional multilayer circuit board.

As described above, in the multilayer circuit board of the Embodiment 3, it is configured that the overlapping area between the component pad 1a and the ground layer is made smaller even when the lamination deviation occurs. Thus, similarly to the Embodiment 1, the variation of the capacitance is suppressed, and as a result, mismatching of the characteristic impedance is decreased, thereby improving the reflection characteristic.

Note that, when no lamination deviation occurs, substantially equivalent values can be obtained in the reflection characteristics between the multilayer circuit board of the Embodiment 3 and a conventional multilayer circuit board in which the conductor in the first ground elimination portion 3a is eliminated in each of the upper and lower ground layers in the strip line.

In the Embodiment 3, it is described that the auxiliary ground conductor 2b, the first ground elimination portion 3a, and the second ground elimination portion 3b, which are similar to those in Embodiment 1, are provided in each of the upper and lower ground layers in the strip line. In addition, it may be configured that the side surface of the first ground elimination portion 3a is formed in an alternating convex and concave shape, similarly to the

### Embodiment 2.

It is to be understood that a free combination of the individual Embodiments, variations of any components of the individual Embodiments or removal of any components are possible within the scope of the present invention.

### INDUSTRIAL APPLICABILITY

As described above, a multilayer circuit board of the present invention relates to the one formed by laminating at least one signal layer and at least one ground layer with an insulating layer interposed therebetween, and is suitable for use in a mounting part of a chip component, a connector or the like.

### REFERENCE SIGNS LIST

1a: component pad
1b: transmission line
2a: ground conductor
2b: auxiliary ground conductor
3a: first ground elimination portion
3b: second ground elimination portion
4: dielectric layer

## Claims

1. A multilayer circuit board formed by laminating at least one signal layer and at least one ground layer with an insulating layer interposed therebetween, the multilayer circuit board comprising:
a transmission line formed in the signal layer;
at least one conductor pad that is formed in the signal layer and connected to the transmission line, and that is wider than the transmission line;
a ground conductor that is formed in the ground layer, and that has a first ground elimination portion in which a conductor is not disposed; and
an auxiliary ground conductor that is disposed inside the first ground elimination portion and that is connected to the ground conductor,
wherein the first ground elimination portion is formed in a size such that a characteristic impedance determined by the first ground elimination portion and the at least one conductor pad is higher than a characteristic impedance determined by the ground conductor and the transmission line.

2. The multilayer circuit board according to claim 1, wherein the at least one conductor pad is a pair of conductor pads, and when an outer shape of the conductor pads is projected on the ground layer, a center of a region between the conductor pads is positioned at a center of the first ground elimination portion.

3. The multilayer circuit board according to claim 1, wherein a center of the auxiliary ground conductor is arranged at a center of the first ground elimination portion.

4. The multilayer circuit board according to claim 1, wherein a second ground elimination portion is formed inside the auxiliary ground conductor, and
when an outer shape of the at least one conductor pad is projected on the ground layer, the at least one conductor pad is arranged inside the second ground elimination portion.

5. The multilayer circuit board according to claim 1, wherein a surface of the auxiliary ground conductor facing the at least one conductor pad has an alternating convex and concave shape.

6. The multilayer circuit board according to claim 1, wherein each of the auxiliary ground conductor and the first ground elimination portion has a shape of line symmetry.
